# EUROPÄISCHE PATENTSCHRIFT

(11) **EP 2 567 927 B1**
(45) Veröffentlichungstag und Bekanntmachung des Hinweises auf die Patenterteilung: **26.02.2014**
(21) Anmeldenummer: 11008339.1
(22) Anmeldetag: 17.10.2011
(51) Int. Cl.: B66B 13/22, H03K 17/968

(54) **Sicherungsvorrichtung sowie Aufzugvorrichtung**
Safety device and lift device
Dispositif de sécurisation et dispositif d'ascenseur

(30) Priorität: 06.09.2011 EP 11007224
(43) Veröffentlichungstag der Anmeldung: 13.03.2013
(73) Patentinhaber: CEDES AG, 7302 Landquart (CH)
(72) Erfinder: De Coi, Beat, 7320 Sargans (CH); Leutenegger, Tobias, 7000 Chur (CH); Hersche, Dumeng, 7402 Bonaduz (CH); Hegelbach, Jürg, 9463 Oberriet (CH)
(74) Vertreter: Otten, Roth, Dobler & Partner

(56) Entgegenhaltungen:
- DE-A1-102009 037 347
- GB-A- 876 371

## Beschreibung

Die Erfindung betrifft eine Sicherungsvorrichtung für Aufzugvorrichtungen nach dem Oberbegriff des Anspruchs 1 sowie eine für Aufzugvorrichtungen nach dem Oberbegriff des Anspruchs 8, ferner ein Verfahren zum Nachrüsten nach dem Oberbegriff des Anspruchs 10 und eine Nachrüstvorrichtung nach dem Oberbegriff des Anspruchs 13.

Bekannt sind aus dem Stand der Technik, wie zum Beispiel DE 10 2009 037347 A1, handelsübliche Sicherungsvorrichtungen für Aufzüge, welche elektrische bzw. elektromechanische Kontakte und Schalter verwenden, um den Verriegelungs- bzw. Schließzustand einer Aufzugstür zu bestimmen. Die Fahrt einer Aufzugkabine soll dabei nur zugelassen werden, wenn sämtliche Türen verriegelt sind.

Aufgabe der Erfindung ist es, eine Sicherungsvorrichtung sowie eine Aufzugvorrichtung vorzuschlagen, bei denen die Wartungsanfälligkeit verbessert werden kann.

Die Aufgabe wird, ausgehend von einer Sicherungsvorrichtung sowie eine Aufzugvorrichtung der eingangs genannten Art, durch die kennzeichnenden Merkmale der Ansprüche 1, 8, 10 und 13 gelöst.

Durch die in abhängigen Ansprüchen genannten Maßnahmen sind vorteilhafte Weiterbildungen und Ausführungen der Erfindung möglich.

Eine Sicherungsvorrichtung für Aufzugvorrichtungen, die über einen Antrieb eine Kabine verfahren können, umfassend: einen ersten Sicherheitskreis, der einen geschlossenen und einen geöffneten Leitungszustand aufweist, mit einer Unterbrechungsvorrichtung zum Unterbrechen des Antriebs in Abhängigkeit vom Leitungszustand des ersten Sicherheitskreises, und einer zusätzlichen Sicherheitseinrichtung, die wenigstens zwei Sensoren umfasst, welche in Abhängigkeit vom Schließzustand der Aufzugstür zwischen wenigstens zwei Schaltzuständen schaltbar sind, sieht vor, dass eine Schalteinheit vorhanden ist, die durch Verbindung mit der Sicherheitseinrichtung zwischen wenigstens zwei Schaltzuständen schaltbar ist. Ferner ist die Schalteinheit dazu ausgebildet, den geschlossenen und/oder geöffneten Leitungszustand des ersten Sicherheitskreises zu bewirken. Die Unterbrechungsvorrichtung dient zum Unterbrechen des Antriebs, wobei die Unterbrechung davon abhängt, wie die Schaltzustände der Schalteinheit und darüber hinaus sonstiger Schalter im ersten Sicherheitskreis sind, dass heißt davon, ob tatsächlich alle Türen verriegelt sind. Durch diese Maßnahme kann entsprechend die Wartungsanfälligkeit verbessert und die Sicherheit des Aufzugs erhöht werden.

Sind mehrere Türen vorhanden, so kann die Fahrt nur begonnen oder fortgesetzt werden, wenn alle Türen verriegelt sind. Dementsprechend ist es zweckmäßig, wenn die entsprechenden Sensoren, welche jeweils einer Tür zugeordnet sind, in Serie geschaltet sind.

Der erste Sicherheitskreis weist beispielsweise Öffnungsschalter und ein Relais / Schütz als Unterbrechungsvorrichtung auf. Die Öffnungsschalter können bei herkömmlichen Sicherheitskreisen als elektromechanische Schalter ausgebildet sein. Wird ein geöffneter Leitungszustand bewirkt, also der erste Sicherheitskreis unterbrochen, so öffnet auch das Relais bzw. das Schütz und unterbricht zum Beispiel einen Motor des Aufzugs.

Die Sicherheitseinrichtung kann gewissermaßen als Ersatzschaltung für einzelne Öffnungsschalter oder für alle Öffnungsschalter angesehen werden, die den Schließzustand bzw. Verriegelungszustand der Tür überwachen. Grundsätzlich kann es sich bei der Sicherheitseinrichtung auch um einen zweiten Sicherheitskreis handeln.

Die Sicherheitsseinrichtung kann dementsprechend erfindungsgemäß als zweiter Sicherheitskreis ausgebildet sein, der wenigstens zwei Sensoren umfasst, welche in Abhängigkeit vom Schließzustand der Aufzugstür zwischen wenigstens zwei Schaltzuständen schaltbar sind. Die Unterbrechungsvorrichtung kann jedoch dazu ausgebildet sein, unter anderem in Abhängigkeit vom Schaltzustand einer Schalteinheit (nicht des Sensors unmittelbar) den Antrieb zu unterbrechen und/oder fortzusetzen. Die Schalteinheit wiederum ist durch Verbindung mit dem Sicherheitskreis zwischen wenigstens zwei Schaltzuständen schaltbar. Somit sind die Unterbrechungsvorrichtung und das Schalten der Unterbrechungsvorrichtung zwar vom Sicherheitskreis abhängig, jedoch nicht direkt an diesen gekoppelt, sondern indirekt über eine zwischengeschaltete Schalteinheit. Diese Vorrichtung ermöglicht gewissermaßen, dass der Sicherheitskreis bzw. die Anordnung von Sensoren als eine separate Vorrichtung "entkoppelt" wird. Dies kann insbesondere dann vorteilhaft sein, wenn für die Unterbrechungsvorrichtung eine Vorrichtung mit vergleichsweise hohen Spannungen benötigt wird. Eine derartige Vorrichtung bietet entsprechende Nachteile bei der Montage bzw. bei der Wartung, da gegebenenfalls spannungsführende Teile mit relativ hoher Spannung berührt werden könnten; bei der erfindungsgemäßen Sicherungsvorrichtung können diese Nachteile vermieden werden. Der Sicherheitskreis selbst kann allerdings grundsätzlich mit relativ niedrigen Spannungen betrieben werden.

Ferner können die Sensoren wiederum in Serie geschaltet werden. Insbesondere dann, wenn eine derartige Entkopplung erfolgt ist, ist es vorteilhaft gegebenenfalls einen Störzustand eines Sensors zu erkennen. Bei einer gewöhnlichen Serienschaltung jedoch kann grundsätzlich nicht wahrgenommen werden, welcher Sensor möglicherweise durch einen Defekt unterbrochen ist. Bei einer großen Anzahl von Sensoren erfordert dies bei einer wartung einen entsprechenden Zeit-und somit auch einen entsprechenden Kostenaufwand. Dem kann dadurch entgegnet werden, dass eine Anzeigevorrichtung zur Anzeige des Schaltzustandes der einzelnen Sensoren mit Zuordnung der einzelnen Schaltzustände zu den entsprechenden Sensoren vorgesehen ist. Grundsätzlich ist eine entsprechende Anzeigevorrichtung im Stande, anzuzeigen, welche der Sensor welchen Schaltzustand gerade aufweist bzw. welcher Sensor einen bestimmten Schaltzustand gerade nicht aufweist, beispielsweise welcher Sensor geöffnet ist.

Insbesondere kann bei einer Weiterbildung der Erfindung die Sicherheitseinrichtung auch als Bussystem ausgebildet sein, wobei die Sensoren jeweils eine Elektronikeinheit aufweisen. Ferner ist der Sensor über seine entsprechende Elektronikeinheit an den Bus angeschlossen. Ein derartiger Bus ermöglicht insbesondere die Übertragung und/oder den Austausch von Daten. Beispielsweise können so auf Befehl Daten einzelner Sensor ausgelesen werden. Denkbar ist grundsätzlich ein bidirektional arbeitender Bus, bei dem Daten gesendet und empfangen werden können. Grundsätzlich ist allerdings auch ein undirektionaler Bus denkbar. Als Daten ist es möglich, die Schaltzustände zu übermitteln, es können aber auch Identifizierungsdaten der Sensor übertragen werden, welche Auskunft darüber geben, um welchen Sensor es sich gerade handelt. Diese Identifizierungsdaten können beispielsweise auch Adressierungen der einzelnen Sensoren sein. Hierdurch wird auf eine besonders elegante Art und Weise ermöglicht, auszulesen, welcher Sensor gerade einen bestimmten Zustand anzeigt. Ferner können Bussysteme gegebenenfalls auch besonders schnell arbeiten.

Bei einer bevorzugten Weiterbildung der Erfindung ist wenigstens einer der Sensoren wie folgt aufgebaut: Ein Sensor für Sicherungsvorrichtungen für Aufzugvorrichtungen, die über einen Antrieb eine Kabine verfahren können, wobei der Sensor als optischer Sensor ausgebildet ist, der einen Sender zum Senden eines optischen Signals und einen Empfänger zum Empfangen des optischen Signals umfasst. Besonders vorteilhaft ist an dem Sensor, dass dieser berührungslos, dass heißt auch verschleißfrei arbeiten kann. Zudem weist der Sensor somit keine oder weniger spannungsführende Kontaktflächen auf und ist darüber hinaus montagesicher. Der erfindungsgemäße Sensor kann deshalb einen handelsüblichen Schalter, einen sog. Interlock switch, aus dem Stand der Technik ersetzen. Zudem ermöglicht der Sensor, dass im Gegensatz zu einem elektromechanischen Schalter keine Unterbrechung des Stromkreises erfolgen muss.

Durch den Sensor kann auch ein Defekt vermieden werden, der z.B. bei elektromechanischen Sensoren und Kontakten durch Kontaktbrand infolge von Funkenüberschlag beim Öffnen bzw. Schließen der elektrischen Kontakte erfolgen und schließlich zum Funktionsverlust führen kann.

Dadurch, dass bei dem Sensor der Stromkreis im Gegensatz zu einem Schalter nicht unterbrochen werden muss, ist in vorteilhafter Weise eine verbesserte Diagnose bei Defekten möglich.

Zudem sind eine Kontaktbrücke und ein Kontaktnehmer zur Aufnahme der Kontaktbrücke vorgesehen, welche so angeordnet sind, dass der Schließzustand der Aufzugstür durch Verbindung von Kontaktnehmer und Kontaktbrücke bestimmbar ist. Der Detektionszustand des Sensors hängt daher von der Annäherung der Kontaktbrücke an den Kontaktnehmer ab.

Ein Aufzug selbst besitzt im Allgemeinen zum einen eine Kabine, welche zwischen einzelnen Stockwerken bzw. Etagen verfahren werden kann. Die einzelnen Etagen besitzen jeweils Schachtöffnungen, in deren Bereich die Kabine in eine Halteposition gefahren werden kann, wenn diese die entsprechende Etage anfahren soll. In dieser Halteposition wird dann ein Zugang zur Kabine ermöglicht. Dieser Zugang kann dadurch ermöglicht werden, dass die Aufzugtüren geöffnet und dann vor der Weiterfahrt wieder geschlossen und verriegelt werden. Aufzugtüren können Schachttüren oder Kabinentüren sein. Die Schachttüren sind im Bereich der Schachtöffnung am Schacht selbst befestigt bzw. verfahrbar gelagert. Die Kabinentüren wiederum sind an der Kabine befestigt und fahrbar gelagert. Regelmäßig ist einer Schachttür jeweils eine Kabinentür zugeordnet, wobei beide in Halteposition überlappend (zumindest teilweise überlappend) angeordnet sind. Regelmäßig werden diese auch zumindest im Wesentlichen synchron verfahren.

Damit eine Fahrt in der Kabine aufgenommen werden kann bzw. die Kabine weiter in Fahrt bleiben kann, ist es notwenig, dass sämtliche Türen verschlossen und verriegelt sind. Dies kann über entsprechende Sicherungsvorrichtungen überprüft werden, welche mittels einer Unterbrechervorrichtung gegebenenfalls den Antrieb stoppen kann. Grundsätzlich kann die Unterbrechungsvorrichtung bzw. Unterbrechungskreis die Kontrolleinheit, d. h. Steuerung bzw. Regelung, des Motors bzw. des Antriebs ansprechen, sodass diese den Antrieb stoppt, denkbar ist auch dass die Unterbrechungsvorrichtung direkt die Stromversorgung des Antriebs / Motors unterbricht.

Der entsprechende Sensor ist somit dafür ausgebildet, zu überprüfen, ob die entsprechende Tür eines Aufzugs bzw, eines Schachts offen oder geschlossen und verriegelt ist. Vorliegend ist es besonders vorteilhaft, den Sensor ähnlich einer Steckverbindung auszubilden, sodass eine Kontaktbrücke in einen Kontaktschacht eingreifen kann. Zudem ermöglicht diese Maßnahme eine mechanisch sehr stabile Vorrichtung. Grundsätzlich kann der Sensor so ausgebildet sein, dass die Kontaktbrücke mit Spiel oder formschlüssig in den Schacht des Kontaktnehmers aufgenommen wird.

Ferner ist die Kontaktbrücke so ausgebildet, dass sie wenigstens ein Übertragungselement zur Übertragung eines optischen Signals umfasst. Hierdurch kann insbesondere in vorteilhafter Weise eine sogenannte Fail-safe-Schaltung, also eine ausfallsichere Schaltung erreicht werden. Lediglich dann, wenn die Kontaktbrücke durch entsprechende Verbindung mit dem Kontaktnehmer beim Schließen der Tür eine spezielle Position erreicht hat, kann eine entsprechende Freigabe für die Fahrt erteilt werden. Bei einer bloßen Lichtschranke wäre dies grundsätzlich nicht der Fall: Das Übertregungselement kann nämlich so ausgebildet sein, dass die Übertragung des optischen Signals auf eine spezielle Art und Weise erfolgt, die nur sehr schwer manipuliert werden kann und auch nicht zufällig ohne weiteres realisiert wird. würde es sich beispielsweise um eine bloße Lichtschranke handeln, welche beim Schließen der Tür unterbrochen würde, so würde dies bedeuten, dass der Antrieb auch dann freigegeben würde, wenn z. B. ein entsprechender Gegenstand, eine Fliege oder Ähnliches die Lichtschranke unterbricht.

Es bietet sich außerdem an, den Sender bzw. den Empfänger am Kontaktnehmer anzuordnen. Die Übertragung des Lichts über das Übertragungselement kann dann lediglich über die Kontaktbrücke erfolgen. Durch diese Ausbildung wird eine besonders kompakte Bauweise ermöglicht.

Eine Möglichkeit besteht darin, das Übertragungselement als Reflexionsfläche auszubilden, wobei diese dann das optische Signal bzw. das Licht reflektiert und nur so auf den entsprechenden Empfänger leitet. Die Reflexionsfläche kann zum Beispiel in einer Kerbe in der Kontaktbrücke angeordnet sein. Denkbar ist jedoch ferner, dass es sich bei dem Übertragungselement um ein optisches Medium handelt, Denkbar ist beispielsweise, dass die Lichtbrechung beim Übergang von der Luft in dieses optische Medium ausgenutzt wird und der Lichtstrahl somit in eine gewisse Richtung gelenkt wird, sodass nur dann entweder auf dem Empfänger oder gerade nicht auf den Empfänger geleitet wird.

Als optisches Medium kann ferner ein Lichtleiter vorgesehen sein. Das optische Signal wird dann übertragen, wenn dessen Licht in den Lichtleiter eingekoppelt wird, durch den Lichtleiter propagiert und über den Lichtleiter in den Empfänger gelangt.

Besonders vorteilhaft ist es, den Sender als Leuchtdiode und/oder dem Empfänger als Photodiode auszubilden. Es handelt sich dabei um besonders günstige Standardelektronikbauteile; hierdurch können insbesondere Kosten eingespart werden.

Im Übrigen ist auch denkbar, dass der Kontaktnehmer Übertragungselemente zur Übertragung des optischen Signals umfasst, z.B. Reflexionsflächen oder optische Medien wie z.3. Lichtleiter. Denkbar ist, dass eine Teilstrecke des Propagationsweges des optischen Signals vom Sender zum Empfänger über eine Reflexionsfläche bzw. durch einen Lichtleiter im Kontaktnehmer erfolgt. Denkbar ist auch, dass durch Aufnahme der Kontaktbrücke der Lichtleiter im Kontaktnehmer oder in der Kontaktbrücke so verschoben wird, dass eine Übertragung des Lichts ermöglicht wird.

Des Weiteren kann der Sensor eine Elektronikeinheit zur Auswertung des Empfängers umfassen, welche dazu ausgebildet ist, die Auswertung des Empfängers in einem der Schaltzustände und/oder in ein elektrisches Signal zu interpretieren. Dies bedeutet, dass die Elektronikeinheit dazu ausgebildet ist, ein elektrisches Signal zu erzeugen oder einen elektrischen Kontakt herzustellen. Da jedoch der mechanische Schließzustand auf rein optischem Wege detektiert wird, bedeutet dies, dass nicht zwingend wieder eine Herstellung eines mechanischen Kontaktes oder eines mechanischen Öffnungszustandes notwendig ist, um ein elektrisches Signal zu erhalten. Denkbar ist beispielsweise, dass das optische Signal den Empfänger, beispielsweise eine Photodiode, durchschaltet und somit ein Leitungszustand (im Gegensatz zu einer Unterbrechung) erreicht werden kann. Hierdurch wird gewissermaßen elektronisch eine Interpretation des Schaltzustandes des Sensors durchgeführt. Die Elektronikeinheit kann allerdings auch zusätzlich dazu ausgebildet sein, eine Anbindung an weitere Elektronik zu ermöglichen. Beispielsweise kann sie auch dazu ausgebildet sein, eine Anbindung an einen Bus zu ermöglichen. Durch diese Ausbildung kann insbesondere noch einmal die geringere Wartungsanfälligkeit verbessert werden, da mechanische Kontakte und Sensor im Wesentlichen vermieden werden. Besonders vorteilhaft ist auch, dass als mechanischer Kontaktschluss lediglich das Eindringen der Kontaktbrücke in den Kontaktnehmer notwendig ist.

Damit kein Streulicht zufällig vom Sender in den Empfänger gelangt, kann zusätzlich ein Trennsteg zur optischen Trennung von Sender und Empfänger vorgesehen sein. Dies verringert noch einmal grundsätzlich die Möglichkeit, dass Fehler aufgrund einer falschen Interpretation der Signale auftreten. Zusätzlich kann im Übrigen auch ein Diffusor vorgesehen sein, welcher Streulicht diffus verbreitet. Denkbar ist ferner, dass der Empfänger bei der Detektion auf einen gewissen Schwellwert hinsichtlich der Intensität des einfallenden Lichtes eingestellt wird, sodass bei einer gewissen Menge von Streulicht, die gegebenenfalls in den Empfänger hineinfällt, nicht dennoch ein entsprechendes Folgesignal ausgelöst wird, welches lediglich dann aufgelöst werden sollte, wenn über das Übertragungselement Licht in dem Empfänger fällt.

Besonders robust kann beispielsweise eine Verbindung hergestellt werden, bei der der Kontaktnehmer einen Schacht und die Kontaktbrücke eine zungenförmige Lasche umfasst, welche bei Verbindung von Kontaktbrücke und Kontaktnehmer in den Schacht eingreift. Besonders vorteilhaft ist dabei auch, dass eine entsprechende Codierung vorgenommen werden kann, dass heißt, dass die Kontaktbrücke, ähnlich wie ein Schlüssel, besonders ausgebildet sein muss, damit sie in den Kontaktnehmer eindringen kann. Dies kann insbesondere die Sicherheit dieser Vorrichtung erhöhen, insbesondere dann, wenn der Kontaktnehmerschacht so ausgebildet ist, dass keine Hand eindringen kann.

Es können ebenfalls bei einem entsprechenden Sensor wenigstens zwei Übertragungselemente vorgesehen sein, welche in Bewegungsrichtung der Kontaktbrücke hintereinander angeordnet sind, das bedeutet, dass beim Verriegeln der Tür die Kontaktbrücke entsprechend in den Kontaktnehmer eintaucht und zunächst für das optische Signal bzw. den optischen Lichtstrahl eines der Übertragungselemente (nämlich das erste in Bewegungsrichtung) sichtbar wird. Beim Weiterschieben wird anschließend das nächste Übertragungselement sichtbar, während das vorangegangene aus dem optischen Weg heraus geschoben wird. Es können somit zeitlich versetzt mehrere optische Signale auftreten. Ferner ist es denkbar, die Elektronikeinheit sc auszubilden oder die entsprechenden Signale an eine weitere Auswerteeinheit weiter zu leiten, sodass beispielsweise das Auftreten der entsprechenden Signale in Abhängigkeit von der Zeit ermittelt wird. Darüber können Rückschlüsse über die Geschwindigkeit der Verriegelung ermittelt werden. Dies ermöglicht auch einen Rückschluss auf den Funktions- und Wartungszustand der Verriegelungseinrichtung der Türe. Grundsätzlich wird im Übrigen die verriegelung, nicht der Türschluss überwacht. Je nach dem, wie die entsprechenden übertragungselemente angeordnet sind bzw. wie viele der Übertragungselemente angeordnet sind, kann gegebenenfalls die Präzision einer solchen Bestimmung erhöht werden.

Grundsätzlich kann der erste Sicherheitskreis auch weiterhin elektromechanische Öffnungsschalter aufweisen. Gegebenenfalls sollen diese zum Beispiel bei einem bestehenden Aufzugsystem verbleiben und nicht beispielsweise beim Nachrüsten durch optische Sensoren entsprechen ausgetauscht werden. Optische Sensoren können insbesondere zum Überprüfen der ordnungsgemäßen Verriegelung von Aufzugtüren vorgesehen sein. Falls der Aufzug in seiner Bewegung aber auch dann gestoppt werden soll, wenn die Verriegelung zwar korrekt erfüllt wurde, ein sonstiger Störfall jedoch vorliegt, können zur Überprüfung derartiger Störfälle gegebenenfalls auch weiterhin elektromechanische Öffnungsschalter verwendet werden.

Die Sensoren und/oder Öffnungsschalter können in Serie geschaltet sein, damit im Falle einer Unterbrechung der Antrieb gestoppt wird. Die Schaltung entspricht damit einer UND-Schaltung, d.h. der Motor läuft nur dann, wenn alle Sensoren bzw. Öffnungsschalter durchschalten und die Leitung nicht unterbrechen.

Ebenso kann eine entsprechende Anzeigevorrichtung vorgesehen sein, welche es beispielsweise ermöglicht, zu identifizieren welcher der Sensor gerade einen bestimmten Schaltzustand besitzt und möglicherweise defekt ist.

Des Weiteren kann der Sensor eine Elektronikeinheit zur Auswertung des Empfängers umfassen, welche dazu ausgebildet ist, die Auswertung des Empfängers in einem der Schaltzustände und/oder in ein elektrisches Signal zu interpretieren. Dies bedeutet, dass die Elektronikeinheit dazu ausgebildet ist, ein elektrisches Signal zu erzeugen oder einen elektrischen Kontakt herzustellen. Da jedoch der mechanische Schließzustand auf rein optischem Wege detektiert wird, bedeutet dies, dass nicht zwingend wieder eine Herstellung eines mechanischen Kontaktes oder eines mechanischen Öffnungszustandes notwendig ist, um ein elektrisches Signal zu erhalten. Denkbar ist beispielsweise, dass das optische Signal den Empfänger, beispielsweise eine Photodiode, durchschaltet und somit ein Leitungszustand (im Gegensatz zu einer Unterbrechung) erreicht werden kann. Hierdurch wird gewissermaßen elektronisch eine Interpretation des Schaltzustandes des Sensors durchgeführt. Die Elektronikeinheit kann allerdings auch zusätzlich dazu ausgebildet sein, eine Anbindung an weitere Elektronik zu ermöglichen. Beispielsweise kann sie auch dazu ausgebildet sein, eine Anbindung an einen Bus zu ermöglichen, Durch diese Ausbildung kann insbesondere noch einmal die geringere Wartungsanfälligkeit verbessert werden, da mechanische Kontakte und Sensor im Wesentlichen vermieden werden. Besonders vorteilhaft ist auch, dass als mechanischer Kontaktschluss lediglich das Eindringen der Kontaktbrücke in den Kontaktnehmer notwendig ist.

Bei einer Weiterbildung der Erfindung ist die Elektronikeinheit zur Kommunikation mit einer Schalteinheit, insbesondere zur Übermittlung von Schaltzuständen und/oder Identifikationssignalen. Die Schalteinheit ist ein Bauteil, mit dem durch einen Schaltvorgang ein Leitung geöffnet oder geschlossen werden kann, ähnlich wie bei einem Relais bzw. Schütz. Der Schaltvorgang wird jedoch dann ausgelöst, wenn von den Sensoren ein entsprechendes Signal bzw. eine entsprechende Information an den die Schalteinheit weitergegeben wird. Vorteilhaft ist insbesondere, dass die Leitung zwischen Schalteinheit und Sensor nicht mehr unterbrochen werden muss, wie es zum Beispiel regelmäßig bei einem Schütz / Relais der Fall ist.

Die Elektronikeinheit kann insbesondere im bzw. am Kontaktnehmer angeordnet sein, in dem auch Sender und Empfänger angeordnet sind. Der Kontaktnehmer kann in der Aufzugvorrichtung z.B. statisch angeordnet sein, während die Kontaktbrücke an einem beweglichen Teil angeordnet ist und lediglich den "schlüssel" darstellt, um die Signalübertragung in dem Kontaktnehmer zu ermöglichen.

Ein Sensor kann genau zwei Anschlüsse umfassen, die zum einen der Stromversorgung und zum anderen der Kommunikation mit der Elektronikeinheit dienen. Zur Kommunikation dient also die gleiche Leitung, die auch zur Stromversorgung verwendet wird. Diese Maßnahme ermöglicht eine besonders kompakte und kostengünstige Bauweise. Zudem wird ermöglicht, dass bei einer Nachrüstung, wenn z.B. ein herkömmlicher Sensor durch einen Sensor gemäß der Erfindung ausgetauscht wird, keine zusätzlichen Leitungen bzw. Anschlüsse verlegt werden müssen.

Ferner kann bei einem Sensor die Kommunikation über eine Modulation seines Eigenwiderstandes des Sensors erfolgen. Im Stromkreis mit der Schalteinheit kann dadurch je nach Schaltung die Spannung und/oder der Stromstärke moduliert werden. Diese Modulation trägt dann die Information, die bei der Kommunikation übertragen werden soll. Denkbar ist z.B, ein Stromkreis, der in Reihe geschaltete Sensoren und (ebenfalls in Reihe geschaltet) eine Schalteinheit umfasst. Wird der Widerstand eines Sensors bei in Reihe geschalteten Sensoren verändert, so ändert sich die Stromstärke. Wir z.B. eine Konstantstromquelle für den Stromkreis verwendet, so bewirkt eine Änderung des Widerstandes, dass die Spannung erhöht werden muss, um die sich ergebende Abnahme der Stromstärke, die durch den geringeren Widerstand zunächst verursacht wird, auszugleichen. Die Modulation kann also Träger der Information sein. Die Änderungen von Stromstärke bzw. Spannung sind messbar und können als Information interpretiert werden.

Die Schalteinheit wiederum ist bei einer Weiterbildung der Erfindung dazu ausgebildet, die Kommunikation mit den Sensoren durch Modulation der Stromstärke bzw. der Spannung durchzuführen. Diese Maßnahme kann durch Änderungen von Widerständen oder entsprechenden Änderungen bzw. Anpassungen von Spannung oder Stromstärke erfolgen.

Bei einer Reihenschaltung ist es insbesondere vorteilhaft, wenn der Sensor einen niedrigen Durchgangswiderstand aufweist. Der Widerstand eines Sensors kann beispielsweise im Bereich von 1 Ohm bis 100 Ohm, insbesondere im Bereich von 5 Ohm bis 20 Ohm, vorzugsweise kleiner als 10 Ohm liegen. Gerade bei einer Reihenschaltung ist es vorteilhaft, den Durchgangswiderstand möglichst klein, insbesondere kleiner als 10 Ohm auszulegen, damit keine zu hohe Spannung über dem Sensor abfällt.

Dementsprechend zeichnet sich ferner eine erfindungsgemäße Aufzugvorrichtung mit einer Kabine und wenigstens einer Aufzugtür zum Öffnen und/oder Verschließen der Kabine sowie mit einer Sicherungsvorrichtung dadurch aus, dass eine erfindungsgemäße Sicherungsvorrichtung vorgesehen sind. Dadurch können unter anderem die bereits geschilderten Vorteile unmittelbar genutzt werden.

Denkbar ist insbesondere, dass die Kontaktbrücke an einer Aufzugstür und der Kontaktnehmer an der Kabine selbst angebracht sind. Grundsätzlich ist allerdings auch ein umgekehrter Aufbau, nämlich der Kontaktnehmer an der Aufzugstür und die Kontaktbrücke an der Kabine denkbar. In Analogerweise können Kontaktbrücke und Kontaktnehmer auch an der Schachttür und am Schacht bzw. der Schachtzarge angeordnet sein.

Der Kontaktnehmer selbst kann des Weiteren ein Gehäuse mit Montageelementen und den bereits geschilderten Einführschlitz für die Kontaktbrücke aufweisen. Die Elektronikeinheit kann als Lichtleiterplatte (englische Abkürzung: PCB) mit einer Leuchtdiode (englische Abkürzung: LED) sowie einer entsprechenden Photodiode als Empfänger ausgestattet sein. Der Trennsteg kann entsprechend zwischen Sender und Empfänger angeordnet werden. Ferner ist auch denkbar, dass entsprechende Kontakte, beispielsweise zur Kontaktierung mit der Fotodiode einen Anschluss an einer entsprechenden Elektronikeinheit ermöglichen. Die Elektronikeinheit kann auch als separates Bauteil oder integriert in einen sonstigen Teil des Aufzugs vorgesehen sein. Grundsätzlich kann der Lichtschluss zwischen Sender und Empfänger gewissermaßen in ein elektrisches Signal umgewandelt werden. Die Kontaktbrücke kann wiederum eine Montageplatte aufweisen, eine entsprechende Zunge mit Lichtleitfasern, wobei in diesem Fall die entsprechenden Lichtleitfasern bei eingefahrener Zunge Licht von der LED zur Photodiode führen können. Gegebenenfalls können die entsprechenden Teile insbesondere auch vormontiert werde.

Besonders vorteilhaft ist an den erfindungsgemäßen Gegenständen, dass fast keine spannungsführenden Kontaktflächen vorgesehen sind, die Montage also sehr sicher erfolgen kann. Die Auswertung der Geschwindigkeit des Beleuchtungsanstiegs an der Photodiode oder der Abfolge der Lichtimpulse zweier Licht-Übertragungselemente erlaubt im Hinblick auf den Wartungszustand den Rückschluss auf die Geschwindigkeit der Verriegelung der Tür. Somit können ferner Informationen über den Wartungszustand bzw. die Alterung der Vorrichtung ermittelt werden. Ferner kann eine Auswertung der endgültigen Beleuchtungsstärke im Zusammenhang mit der zeitlichen Entwicklung der Beleuchtung erfolgen. Dies kann insbesondere einen Rückschluss auf die Eintauchtiefe sowie ferner auf die Verriegelungssicherheit erlauben. Mehrere Übertragungselemente ermöglichen ferner eine dynamische Detektion. Zudem ist es denkbar, die Robustheit dadurch zu erhöhen, dass konstruktive Maßnahmen vorgesehen werden, die das Verdecken der LED bzw. der Photodiode vorsehen. Gerade durch die Ausbildung eines Kontaktnehmers in Form eines Schachtes wird dies besonders vorteilhaft ermöglicht.

Wie bereits erwähnt kann eine separate Auswerteeinheit vorgesehen sein, welche beispielsweise über eine Schnittstelle mit dem entsprechenden Bus kommunizieren kann. Besonders vorteilhaft ist an der erfindungsgemäßen Vorrichtung, dass keine Unterbrechung eines elektrischen Kontaktes vorgesehen ist, sondern lediglich eine Übermittelung eines Signals auf optischem Wege ermöglicht oder verhindert wird.

Ein weiterer Vorteil der Erfindung besteht darin, dass die erfindungsgemäße Vorrichtung besonders gut nachrüstbar ist. Bei einem bestehenden Aufzugsystem war es bislang besonders nachteilig, dass beim Defekt eines Sensors praktisch alle Sensoren in den einzelnen Stockwerken separat diesbezüglich untersucht werden müssen. Zudem ist gegebenenfalls nicht zu erkennen, ob es sich um den Defekt eines einzelnen Sensors oder mehrere Sensor handelt, sodass gegebenenfalls alle Sensor überprüft werden müssen. Die Zustände der Sensor, d. h. defekt oder nicht bzw. geöffnet oder nicht, können über eine Auswerteeinheit auch bequem an einem Rechner, Bedienpult oder Ähnlichem zentral angezeigt werden.

Bei einem entsprechenden erfindungsgemäßen Nachrüstverfahren ist kann die Sicherheitseinrichtung als Austauschteil verwendet werden. Die Verbindung zu den Öffnungsschaltern, z.B. herkömmliche elektromechanische Schalter, kann gekappt werden. Stattdessen wird die Schalteinheit der Sicherheitseinrichtung angeschlossen. Bei Aufzügen kann somit der Aufwand zum Nachrüsten erheblich reduziert werden. Es reicht regelmäßig aus, eine längere Verbindungsleitung über die Stockwerke einzuziehen. Beide Leitungen zu den alten Öffnungsschaltern können zudem meist unkompliziert praktisch an einer einem Ort in der Nähe der Steuerzentrale gekappt werden.

Im Zusammenhang mit dem Nachrüsten wird eine Nachrüstvorrichtung in einer entsprechenden, nachzurüstenden Aufzugvorrichtung eingebaut, wobei die Aufzugvorrichtung einen Sicherheitskreis aufweist, der im Sinne der Erfindung dem ersten Sicherheitskreis entspricht und Öffnungsschalter aufweist. Die erfindungsgemäße Nachrüstvorrichtung umfasst Sensoren, die in Abhängigkeit vom Schließzustand der Aufzugstür zwischen wenigstens zwei Schaltzuständen schaltbar sind. Des Weiteren umfasst die Nachrüstvorrichtung eine Schalteinheit, die anstelle der zu ersetzenden Öffnungsschalter einzusetzen ist. Mittels der Sensoren ist die Schalteinheit schaltbar. Sensoren und Schalteinheit können z.B. über Modulation der Spannung/Stromstärke bzw. des Eigenwiderstandes der Sensoren Informationen austauschen.

### Ausführungsbeispiel:

Ausführungsbeispiele der Erfindung sind in den Zeichnungen dargestellt und werden nachstehend unter Angabe weiterer Einzelheiten und Vorteile näher erläutert.

Im Einzelnen zeigen:
- Figur 1: einen Sensor aus Kontaktbrücke mit Reflexionsstreifen und Kcntaktnehmer gem. der Erfindung,
- Figur 2: ein Kontaktnehmer gem. der Erfindung,
- Figur 3: eine Kontaktbrücke mit Reflexionsstreifen gem. der Erfindung,
- Figur 4: einen Sensor aus Kontaktbrücke mit Lichtleiter und Kontaktnehmer gem. der Erfindung,
- Figur 5: ein Kontaktnehmer gem. der Erfindung, wie in Figur 2,
- Figur 6: eine Kontaktbrücke mit Lichtleiter gem. der Erfindung,
- Figur 7: das Verbinden (zeitlicher Ablauf) von Kontaktbrücke und Kontaktnehmer gem. der Erfindung,
- Figur 8: einen Sensor mit Reflexionsstreifen gem. der Erfindung,
- Figur 9: eine Sicherungsvorrichtung mit Sensoren gem. der Erfindung,
- Figur 10: eine Sicherungsvorrichtung mit Sicherheitskreis gem. der Erfindung,
- Figur 11: eine Sicherungsvorrichtung mit Bus gem. der Erfindung,
- Figur 12: eine Sicherungsvorrichtung mit Bus und integriertem Schütz in der Schalteinheit gem. der Erfindung,
- Figur 13: ein Schaltplan für einen Aufzug gem. der Erfindung,
- Figur 14: einen Sensor mit Lichtleitern gem. der Erfindung,
- Figur 15: eine perspektivische Ansicht des Sensors gem. Figur 14, sowie
- Figur 16: eine schematische Darstellung, wie in einer Sicherungsvorrichtung gem. der Erfindung die Kommunikation mit einzelnen Sensoren stattfindet.

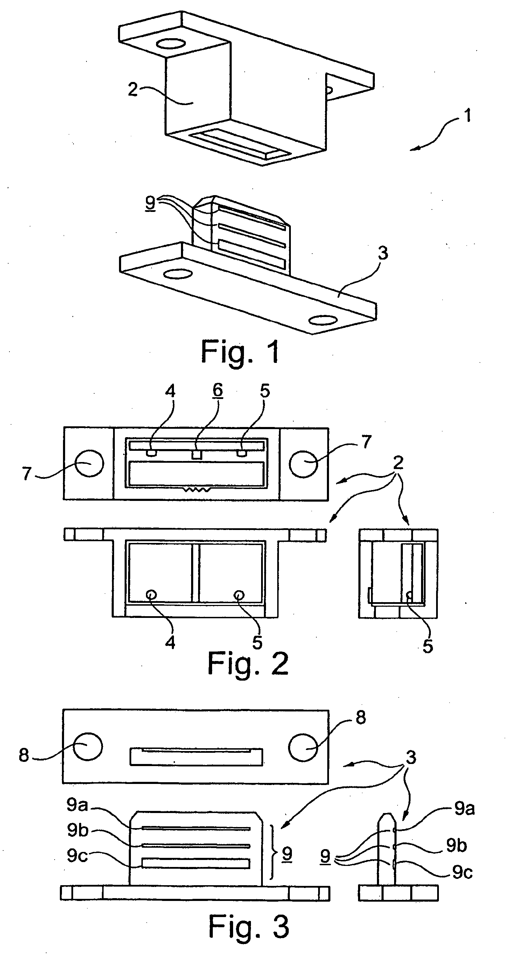

Figur 1 zeigt einen Sensor 1 mit einem Kontaktnehmer 2 (Schacht) und einer Kontaktbrücke 3, wobei die Kontaktbrücke Reflexionsstreifen 9 aufweist, die von einem Sender des Kontaktnehmers 2 ausgestrahltes Licht in Richtung eines Empfängers des Kontaktnehmers 2 reflektieren.

Figur 2 zeigt wiederun den entsprechenden Kontaktnehmer 2 mit einem Sender 4 und einem Empfänger 5, zwischen denen ein Trennsteg 6 angeordnet ist, und zwar in Vorderansicht, Seitenansicht und Draufsicht. Mit dem Bezugszeichen 7 sind Montagevorrichtungen bzw. Montagehilfen angegeben. Der Kontaktnehmer 2 weist zusätzliche elektrische Anschlüsse auf, über welche der Sensor 1 mit der restlichen Sensorvorrichtung bzw. mit dem Sicherheitskreis verbunden werden kann.

Figur 3 zeigt eine Kontaktbrücke in verschiedenen Ansichten und zwar in Vorderansicht, Seitenansicht und Draufsicht. Auch diese umfasst entsprechende Montagehilfen 8. Als Übertragungselemente 9 sind Schlitze in die Kontaktbrücke 3 eingearbeitet, die jeweils Reflexionsflächen aufweisen. Insgesamt gibt es drei Reflexionseinheiten 9a, 9b, 9c, sodass gewissermaßen eine dynamische Kontaktdetektion ermöglicht wird, da beim Eindringen der Kontaktbrücke 3 in den Kontaktnehmer 2 bzw. in den optischen Lichtweg zunächst die Reflexionseinheit 9a, danach die Reflexionseinheit 9b und schließlich 9c eindringen und somit eine dynamische Messung des Signals in zeitlicher Abhängigkeit möglich wird.

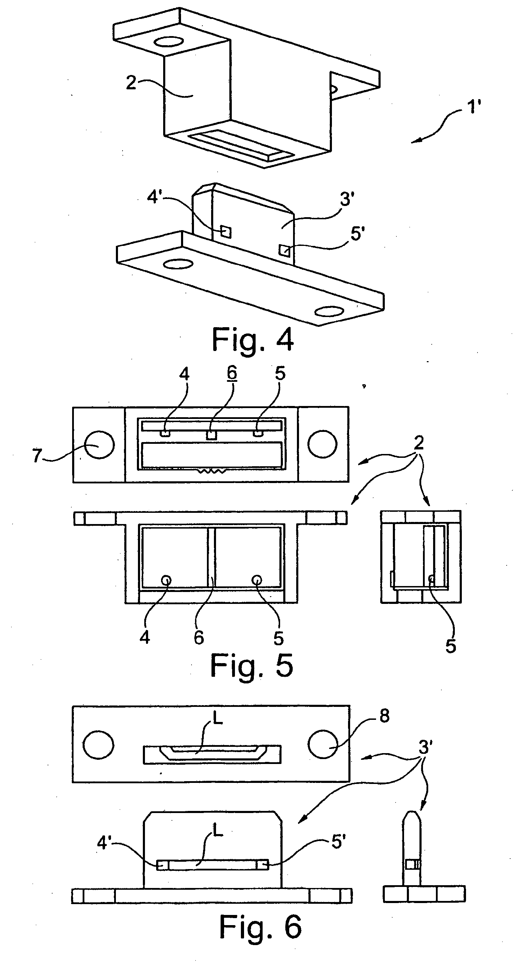

Figur 4 zeigt einen Sensor 1' mit einem Kontaktnehmer 2 (Schacht) und einer Kontaktbrücke 3', wobei die Kontaktbrücke einen Lichtleiter aufweist; das von einem Sender des Kontaktnehmers 2 ausgestrahltes Licht gelangt in den Lichtleitereingang 4', propagiert durch den Lichtleiter und tritt aus dem Lichtleiterausgang 5' wieder aus, sodass es in zum Empfänger des Kontaktnehmers 2 gelangt.

Figur 5 zeigt wiederum den entsprechenden Konzaktnehmer 2, wie er bereits zu Figur 2 beschrieben wurde, der auch für einen Sensor l' mit Lichtleiter geeignet ist.

Figur 6 zeigt eine Kontaktbrücke 3' in verschiedenen Ansichten, und zwar in Vorderansicht, Seitenansicht und Draufsicht. Auch diese umfasst entsprechende Montagehilfen 8. Als Übertragungselement L ist ein Lichtleiter in die Kontaktbrücke 3' eingearbeitet, durch den das vom Kontaktnehmer ausgesendete Lichtsignal propagierten kann. Zu sehen sind auch der Lichteinlass 4' und der Lichtausgang 5'.

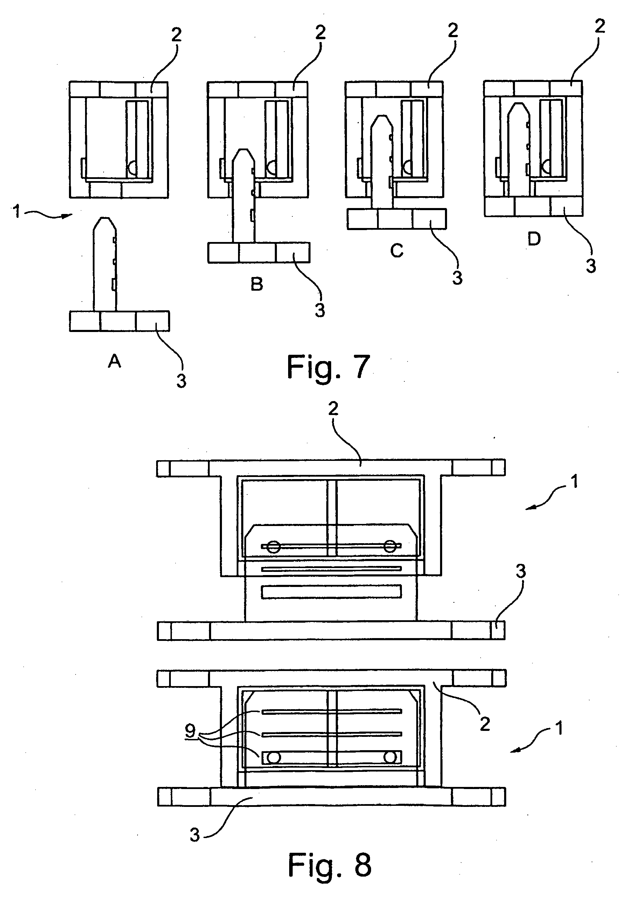

Figur 7 zeigt ein derartiges Eindringen der Kontaktbrücke 3 (mit Reflexionsstreifen) in den Kontaktnehmer 2, wobei in Situation A die Kontaktbrücke noch nicht in Verbindung mit dem Kontaktnehmer 2 steht. In Situation B ist die Reflexionseinheit 9a gerade im Bereich des optischen Weges eingedrungen und überträgt den Lichtweg vom Sender zum Empfänger. In Situation C steht die Kontaktbrücke 3 gerade so, dass eine Unterbrechung des optischen Signals erfolgt, da die Kontaktbrücke 3 in ihrer Höhe gerade zwischen den Reflexionseinheiten 9b und 9c steht und der optische Weg somit unterbrochen ist. Erst in Situation D steht die Kontaktbrücke, welche voll in den Kontaktnehmer 2 eingefahren ist, in einer derartigen Stellung, dass der optische Weg nicht unterbrochen ist und vom Empfänger 4 Licht über das Reflektionselement 9c in den Detektor/die Photodiode gelangen kann. Die Reflexionseinheiten 9, und auch sonstige Übertragungseinheiten wie optische Medien, können verschiedene Formen aufweisen und charakteristische Reflexionen oder Lichtübertragungen bieten, sodass diese jeweils mittels des Empfängers bzw. der Elektronikeinheit auch gegebenenfalls identifiziert werden können.

Figur 8 zeigt eine ähnliche Darstellung, bei der die Kontaktbrücke 3 in den Kontaktnehmer 2 eindringt.

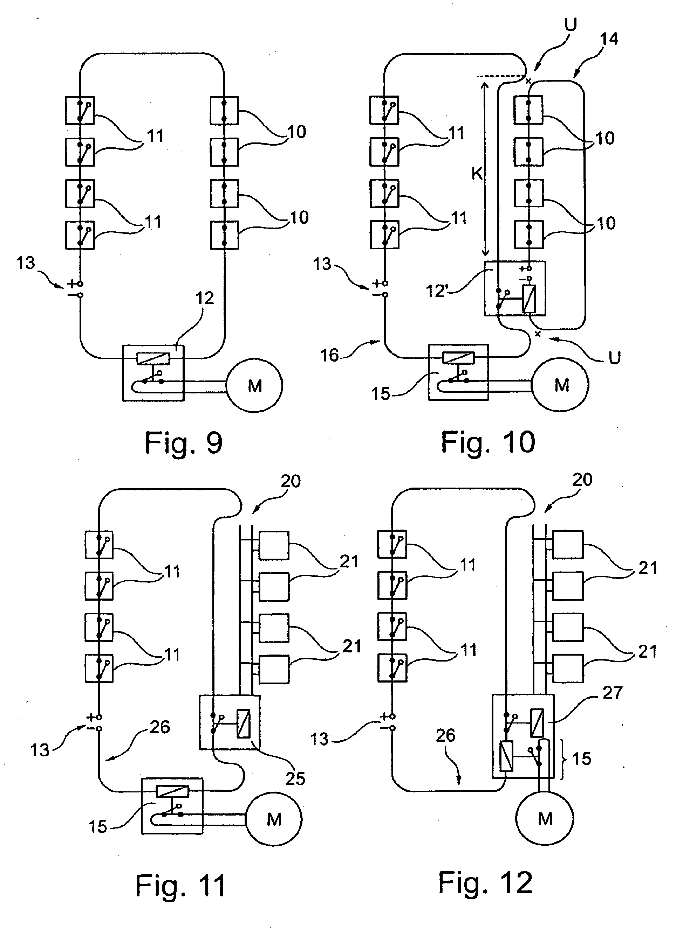

Figur 9 wiederum zeigt eine Sicherungsvorrichtung mit mehreren optischen Sensoren 10, welche alle in Serie geschaltet sind. Des Weiteren sind eine Reihe weiterer elektromechanischer Öffnungsschalter 11 vorhanden, welche in sonstiger Weise in Verbindung mit einem Aufzug verwendet werden können. Zudem ist eine Spannungsquelle 13 vorhanden. Alle diese Schalter bzw. Sensoren 11 und 10 sind in Serie geschaltet und mit einer Schalteinheit 12 verbunden. Dieser Stromkreis aus einer Reihenschaltung der Schalter 11, der Sensoren 10 und der Schalteinheit 12 bildet einen Sicherheitskreis. Ist einer der Schalter 11 unterbrochen, so ist der gesamte Stromkreis unterbrochen, und die Schalteinheit 12 schaltet den Motor M, der den Antrieb für die Aufzugskabine darstellt, ab. Die Schalter 11 können Öffnungsschalter bekannter Art sein. Detektiert einer der Sensoren 10, dass z.B. der Aufzug nicht ordnungsgemäß verriegelt ist, so sendet dieser ein entsprechendes Signal über den Schaltkreis, das von der Kommunikationseinheit der Schalteinheit 12 empfangen wird, sodass sie den Motor M abschalten kann. Dementsprechend übernimmt die Schalteinheit 12 teilweise die Funktion deines Relais; zusätzlich sind Schaltvorgänge der Schalteinheit aber auch abhängig von Signalen der Sensoren. Die Schalteinheit 12 reagiert also nicht nur auf Leitungsunterbrechungen.

Figur 10 zeigt eine Sicherungsvorrichtung mit einer Sicherheitseinrichtung, nämlich einem (zweiten) Sicherheitskreis 14, mit entsprechenden optischen Sensoren 10. Dieser Sicherheitskreis ist über eine Schalteinheit 12' mit dem ersten Sicherheitskreis 16 verbunden, der wiederum weitere Sensor 11 aufweist. Die Schalteinheit 12' ist ähnlich zu der Schalteinheit 12 und besitzt die gleiche Funktionsweise; vorliegend ist im Gegensatz zur Schalteinheit 12 aus Figur 9 jedoch die Spannungsquelle mit in der Schalteinheit 12' integriert. Im ersten Sicherheitskreis 16 befindet sich ein Schütz / Relais 15, welches wiederum einen Antrieb M ausschalten kann. Das Schütz 15 ist lediglich dazu ausgebildet, im Falle einer Leitungsunterbrechung des Kreises 16 den Motor M abzuschalten. Ist einer der Sensoren 10 optisch unterbrochen, so wird auch die Schalteinheit 12' unterbrochen und somit die Leitung des ersten Sicherheitskreises 16. Das Schütz 15 schaltet den Motor M ab. Anstelle der üblichen Öffnungsschalter sind die erfindungsgemäßen Sensoren in einem eigenen Sicherheitskreis 14 zusammengefasst und über die Schalteinheit 12' mit dem ursprünglichen, ersten Sicherheitskreis 16 verbunden. Der Sicherheitskreis 16 kann dabei zum Teil die Verkabelung der ursprünglichen Sicherungsvorrichtung verwenden.

In Figur 10 ist zudem dargestellt, wie eine Nachrüstung einer herkömmlichen Vorrichtung erfolgen kann, indem der ursprüngliche erste Sicherheitskreis 16 an den Stellen U gekappt wird und der zweite Sicherheitskreis 14 mit der Schalteinheit 12' entsprechend eingesetzt wird. Es muss dann nur ein längeres Kabel K eingezogen werden.

Figur 11 zeigt eine entsprechende Vorrichtung bei der statt eines zweiten Sicherheitskreises als Sicherungseinrichtung ein Bus 20 angeordnet ist. Die entsprechenden Sensor 21 weisen eine Elektronikeinheit auf, welche eine Verbindung zu dem entsprechenden Bus 20 ermöglichen. Der Bus ist ebenfalls an eine Schalteinheit 25 angeschlossen, sodass bei Unterbrechen eines der optischen Sensor 21 dieser wiederum ein Signal an die Schalteinheit 25 sendet, welche den ersten Sicherheitskreis 26 wiederum unterbricht. Mit dem Schütz 15 wird aufgrund der unterbrochenen Leitung des Sicherheitskreises 26 der Motor M abgeschaltet. Die Schalteinheit 25 kann z.B. den Master im Bus bilden, während die Sensoren 21 in Slave-Konfiguration vorliegen.

Figur 12 zeigt eine ähnliche Vorrichtung wie Figur 8, jedoch ist hier der Schütz 15 in die Schalteinheit 27 zusätzlich integriert, wobei das Schütz den Motor gegebenenfalls abschaltet.

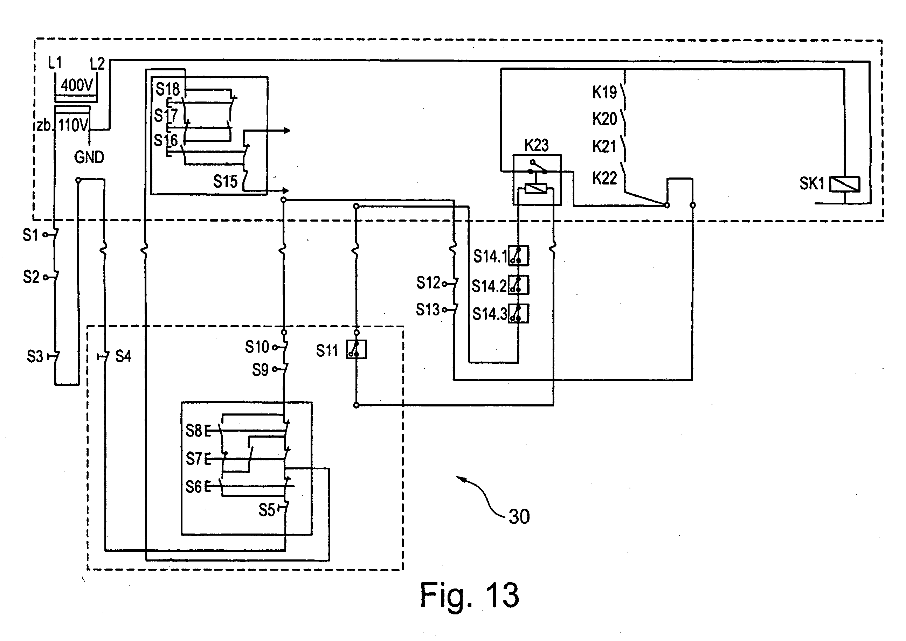

Figur 13 zeigt einen exemplarischen Schaltplan 30 für einen Aufzug gem. der Erfindung.

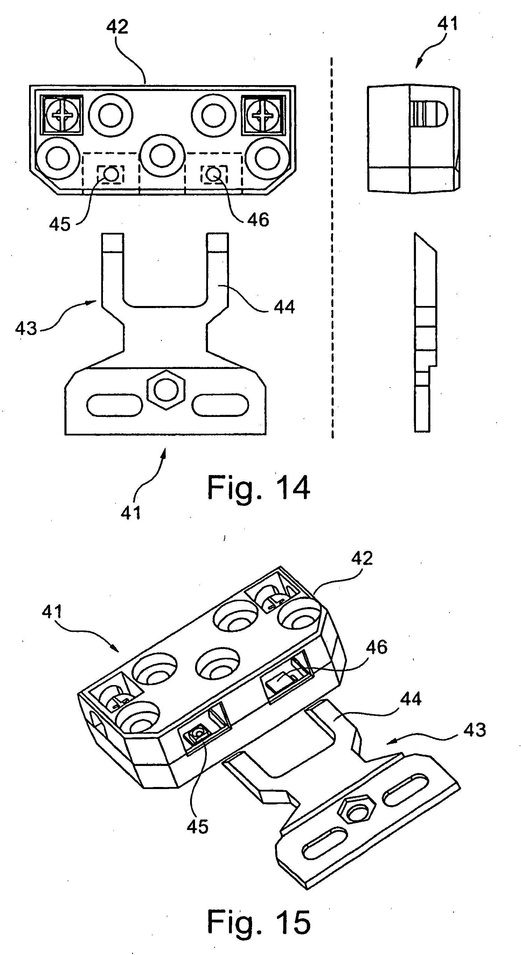

Figur 14 zeigt einen Sensor 41 in Draufsicht und in einer Seitenansicht mit einem Kontaktnehmer 42 und einer Kontaktbrücke 43, in welcher ein Lichtleiter 44 angeordnet ist. Vorliegend ist die Kontaktbrücke 43 insgesamt als Lichtleiter 44 ausgebildet, besteht also aus dem entsprechenden optischen Medium. Der Kontaktnehmer 42 umfasst einen Sender 45 und einen Empfänger 46 zum Senden / Empfangen von optischen Signalen. Das vom Sender 45 ausgesandte optische Signal kann, sobald der Kontaktnehmer 42 die Kontaktbrücke 43 aufgenommen hat, durch den Lichtleiter 44 propagieren und gelangt so in den Empfänger 46. Die Kontaktbrücke 43 (bzw. der Lichtleiter 44) ist U-förmig ausgebildet und greift, wenn sie in den Kontaktnehmer 42 gesteckt wird, lediglich mit den beiden Schenkeln in die beiden Schächte des Kontaktnehmers 42 ein. Der Lichtleiter 44 ist dementsprechend ebenfalls U-förmig ausgebildet. Figur 15 wiederum zeigt den Sensor 41 in einer perspektivischen Ansicht.

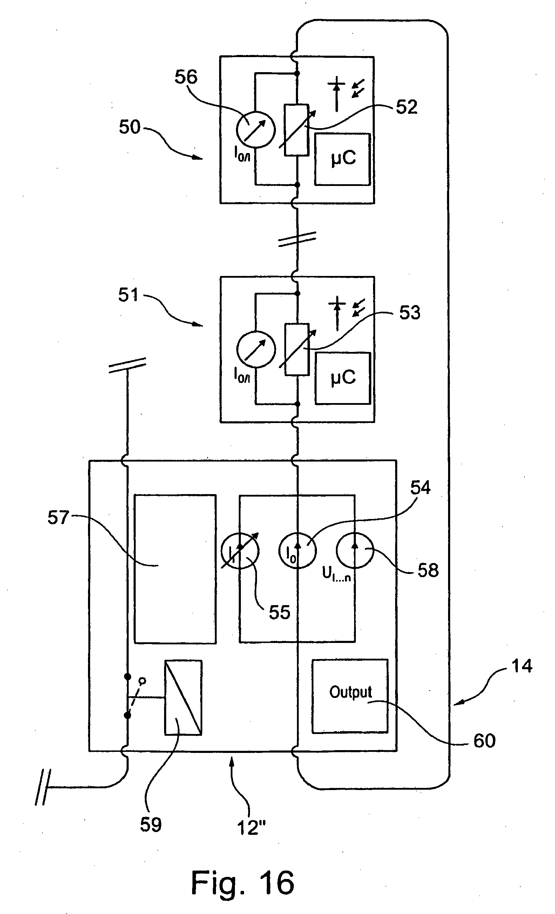

Figur 16 zeigt eine schematische Darstellung der Kommunikation im Sicherheitskreis 14 zwischen dem Controller 57 der Schalteinheit und den einzelnen Sensoren 10 bzw. deren Mikrocontrollern µC dar. Die Kommunikation vom Controller 57 zu den einzelnen Sensoren erfolgt über eine Strommodulation, während umgekehrt vom Sensor 10 zum Controller 57 eine Spannungsmodulation erfolgt.

Regelmäßig ist es erforderlich, dass deutliche Strom- bzw. Spannungsänderungen bzw. -modulationen erfolgen, da wegen der in Aufzugsystem vorkommenden großen Kabellängen die Änderung sonst unmerklich wäre. Zum Beispiel sind Stromänderungen im Bereich von Faktor 3 denkbar.

Die Einheiten 50, 51 entsprechen jeweils einem Sensor. Mit den Bezugszeichen 52, 53 sind veränderbare Widerstände dargestellt. Jedem Sensor ist ein veränderbarer Widerstand zugeordnet. Die Veränderung des Widerstandes kann auf verschiedene Art und Weise erfolgen: Denkbar ist, dass parallel widerstände zu anderen hinzugeschaltet werden, wodurch sich der Gesamtwiderstand entsprechend verringert. Es ist aber auch denkbar, dass schaltungstechrisch, etwa durch Sperren einzelner Transistoren, der Widerstand beeinflusst wird. Die Veränderung des Widerstandes kann optisch beeinflusst werden, z.B. durch Phototransistoren, Photodioden, Optokoppler o. Ä.

Der Stromkreis umfasst Konstantstromquellen 54, 55, die jeweils dazu ausgebildet sind, ihre Spannung bei sich veränderndem Widerstand im Stromkreis so anzupassen, dass ein konstanter Strom fließt. Änderung des Widerstandes (Kommunikation: Controller 57 an Sensor 10) reguliert die Konstantstromquelle 54 auf eine konstante Stromstärke, sodass die über das Spannungsmessgerät 56 gemessene Spannung sich ändert.

Wird eine weitere Konstantstromquelle 55 hinzugeschaltet, so kann auch die Stromstärke moduliert werden, d.h. die Spannung bleibt nicht konstant (Kommunikation: Sensor an Controller) Die Änderung der an den Stromkreis angelegten Spannung kann durch das Spannungsmessgerät 58 ermittelt werden.

Über einen Ausgang 60 können somit die Zustände der einzelnen Sensoren oder sonstige Daten der Sensoren ausgegeben werden. Über den Mikrocontroller 57 wird entsprechend den Sensoren das Relais 59 gesteuert.

In Figur 16 ist eine Schalteinheit 12'' dargestellt, wie z.B. auch in Figur 9 als Schalteinheit 12 oder in Figur 10 als Schalteinheit 12' dargestellt ist. Die Schalteinheit 12' umfasst noch eine Spannungsquelle. Die Schalteinheit 12 aus Figur 9 umfasst insbesondere noch die Funktion eines Relais, das bei Leitungsunterbrechung auch den Motor M abschalten kann. Die Schalteinheit 12 ist in Figur 16 mit einem (zweiten) Sicherheitskreis 14 verbunden.

### Bezugszeichenliste:

- 1: Sensor
- 1': Sensor
- 2: Kontaktnehmer
- 3: Kontaktbrücke
- 3': Kontaktbrücke
- 4: Sender
- 4': Lichtleitereingang
- 5: Empfänger
- 5': Lichtleiterausgang
- 6: Trennsteg
- 7: Montageeinheit
- 8: Montageeinheit
- 9: Reflexionsfläche
- 9a: Reflexionsfläche
- 9b: Reflexionsfläche
- 9c: Reflexionsfläche
- 10: optischer Sensor
- 11: elektromechanischer Öffnungsschalter
- 12: Schalteinheit
- 12': Schalteinheit (mit Spannungsquelle)
- 12": Schalteinheit
- 13: Spannungsquelle
- 14: zweiter Sicherheitskreis
- 15: Schütz / Relais
- 16: Erster Sicherheitskreis
- 20: Bus
- 21: Optischer Sensor mit Elektronikeinheit
- 25: Schalteinheit
- 26: Sicherheitskreis
- 27: Schalteinheit mit integriertem Schütz
- 30: Schaltplan
- 41: Sensor
- 42: Kontaktnehmer
- 43: Kontaktbrücke
- 44: Lichtleiter
- 45: Sender
- 46: Empfänger
- 50: Kommunikationseinheit
- 51: Kommunikationseinheit
- 52: veränderbarer Widerstand
- 53: veränderbarer Widerstand
- 54: Konstantstromquelle
- 55: Konstantstromquelle
- 56: Spannungsmessgerät
- 57: Mikrocontroller der Schalteinheit
- 58: Spannungsmessgerät
- 59: Relais
- 60: Ausgang
- A: Ansicht zu erstem Zeitpunkt
- B: Ansicht zu zweitem Zeitpunkt
- C: Ansicht zu drittem Zeitpunkt
- D: Ansicht zu viertem Zeitpunkt
- K: Kabel / Stromleitung
- L: Lichtleiter
- M: Antriebsmotor
- µC: Mikrocontroller eines Sensors
- U: Unterbrechung

## Patentansprüche

1. Sicherungsvorrichtung für Aufzugvorrichtungen, die über einen Antrieb (M) eine Kabine verfahren können, umfassend:
- einen ersten Sicherheitskreis (16, 26), der einen geschlossenen und einen geöffneten Leitungszustand aufweist, mit einer Unterbrechungsvorrichtung (12, 15) zum Unterbrechen des Antriebs in Abhängigkeit vom Leitungszustand des ersten Sicherheitskreises,
- eine Sicherheitseinrichtung (14, 20), die wenigstens zwei Sensoren (1, 1', 10, 21, 41) umfasst, welche in Abhängigkeit vom Schließzustand der Aufzugstür zwischen wenigstens zwei Schaltzuständen schaltbar sind, wobei eine Schalteinheit (12, 12', 121'', 25, 27) vorhanden ist, die durch Verbindung mit der Sicherheitseinrichtung (14, 20) zwischen wenigstens zwei Schaltzuständen schaltbar ist und dazu ausgebildet ist, den geschlossenen und/oder geöffneten Leitungszustand des ersten Sicherheitskreises zu bewirken, **dadurch gekennzeichnet, dass** die Sicherheitseinrichtung als zweiter Sicherheitskreis (14) ausgebildet ist.

2. Sicherungsvorrichtung nach Anspruch 1, **dadurch gekennzeichnet, dass** wenigstens einer der Sensoren (1, 10) eine Kontaktbrücke (3) und einen Kontaktnehmer (2) zur Aufnahme der Kontaktbrücke umfasst, welche so angeordnet sind, dass der Schließzustand der Aufzugstür durch Verbindung von Kontaktnehmer und Kontaktbrücke bestimmbar ist, wobei der Sensor als optischer Sensor ausgebildet ist, der einen Sender (4) zum Senden eines optischen Signals und einen Empfänger (5) zum Empfangen des optischen Signals umfasst, wobei der Sender und der Empfänger am Kontaktnehmer angeordnet sind und die Kontaktbrücke wenigstens ein Übertragungselement (9; 9a, 9b, 9c) zur Übertragung des optischen Signals umfasst.

3. Sicherungsvorrichtung nach einem der vorgenannten Ansprüche, **dadurch gekennzeichnet, dass** der erste Sicherheitskreis wenigstens einen elektromechanischen Schalter (11) umfasst,

4. Sicherungsvorrichtung nach einem der vorgenannten Ansprüche, **dadurch gekennzeichnet, dass** wenigstens zwei der Sensoren (10) in Serie geschaltet sind.

5. Sicherungsvorrichtung nach einem der vorgenannten Ansprüche, **dadurch gekennzeichnet, dass** eine Anzeigevorrichtung zur Anzeige des Schaltzustandes der einzelnen Sensoren mit Zuordnung der einzelnen Schaltzustände zu den entsprechenden Sensoren vorgesehen ist.

6. Sicherungsvorrichtung nach einem der vorgenannten Ansprüche, **dadurch gekennzeichnet, dass** die Schalteinheit dazu ausgebildet ist, die Kommunikation mit den Sensoren durch Modulation der Stromstärke und/oder der Spannung vorzunehmen.

7. Sicherungsvorrichtung nach einem der vorgenannten Ansprüche, **dadurch gekennzeichnet, dass** der Sensor dazu ausgebildet ist, zur Kommunikation mit der Schalteinheit eine Modulation seines Eigenwiderstandes (52) vorzunehmen.

8. Aufzugvorrichtung mit einer Kabine und wenigstens einer Aufzugtür zum Öffnen und/oder Verschließen der Kabine sowie mit einer Sicherungsvorrichtung zur Verriegelung der Aufzugtür während des Betriebes, **dadurch gekennzeichnet, dass** die Sicherungsvorrichtung nach einem der vorgenannten Ansprüche ausgebildet ist.

9. Aufzugvorrichtung nach Anspruch 8, **dadurch gekennzeichnet, dass** die Kontaktbrücke an wenigstens einer der Aufzugtüren und/oder der Kontaktnehmer an der Kabine angebracht ist/sind.

10. Verfahren zum Nachrüsten einer Sicherungsvorrichtung nach einem der Ansprüche 1 bis 7 in einer Aufzugvorrichtung.

11. Verfahren nach Anspruch 10, **dadurch gekennzeichnet, dass** die Aufzugvorrichtung einen Sicherheitskreis mit wenigstens einem Öffnungsschalter zum Bewirken eines geöffneten bzw. geschlossenen Leitungszustands umfasst, **dadurch gekennzeichnet, dass** in einem ersten Verfahrenschritt der Sicherheitskreis vor und nach dem Öffnungsschalter unterbrochen (U) wird.

12. Verfahren nach Anspruch 10 oder 11, **dadurch gekennzeichnet, dass** in einem zweiten Verfahrenschritt eine Sicherungseinrichtung eingefügt wird, indem anstelle des / der Öffnungsschalter die Schalteinheit eingesetzt wird und die Schalteinheit mit der Sicherungseinrichtung verbunden wird.

13. Nachrüstvorrichtung zum Nachrüsten von Sicherungsvorrichtungen von Aufzugvorrichtungen mit Sicherheitskreisen, die eine Serienschaltung von Öffnungsschaltern umfasst, wobei die Nachrüstvorrichtung eine Sicherheitseinrichtung (14, 20) aufweist, die wenigstens zwei Sensoren umfasst, wobei die Sensoren in Abhängigkeit vom Schließzustand der Aufzugstür zwischen wenigstens zwei Schaltzuständen schaltbar sind, wobei die Sicherheitseinrichtung als zweiter Sicherheitskreis ausgebildet ist und wobei ferner die Nachrüstvorrichtung eine Schalteinheit aufweist, die durch Verbindung mit der Sicherheitseinrichtung zwischen wenigstens zwei Schaltzuständen schaltbar ist, wobei die Schalteinheit anstelle wenigstens eines der Öffnungsschalter in den Sicherheitskreis einsetzbar ist.

## Claims

1. Safety device for lift devices which can move a cab by means of a drive (M), comprising:
- a first safety circuit (16, 26) that has a closed conduction state and an open conduction state, with an interrupting device (12, 15) for interrupting the drive as a function of the conduction state of the first safety circuit,
- a safety device (14, 20) comprising at least two sensors (1, 1', 10, 21, 41), which can be switched between at least two switching states as a function of the closing state of the lift door, wherein a switching unit (12, 12', 12", 25, 27) is provided that can be switched between at least two switching states by connection to the safety device (14, 20) to effect the closed and/or open conduction state of the first safety circuit, **characterised in that** the safety device is configured as a second safety circuit (14).

2. Safety device according to claim 1, wherein at least one of the sensors (1, 10) comprises a contact link (3) and a contact receiver (2) for receiving the contact link, which are arranged so that the closing state of the lift door can be determined by connecting the contact receiver and the contact link, the sensor being in the form of an optical sensor which comprises a transmitter (4) for transmitting an optical signal and a receiver (5) for receiving the optical signal, the transmitter and the receiver being arranged on the contact receiver and the contact link comprising at least one transmission element (9; 9a, 9b, 9c) for transmitting the optical signal.

3. Safety device according to one of the preceding claims, **characterised in that** the first safety circuit comprises at least one electromechanical switch (11).

4. Safety device according to one of the preceding claims, **characterised in that** at least two of the sensors (10) are connected in series.

5. Safety device according to one of the preceding claims, **characterised in that** a display device is provided for displaying the switching state of the individual sensors with the allocation of the individual switching states to the corresponding sensors

6. Safety device according to one of the preceding claims, **characterised in that** the switching unit is configured to perform the communication with the sensors by modulating the current intensity and/or the voltage.

7. Safety device according to one of the preceding claims, **characterised in that** the sensor is configured to perform a modulation of its internal resistance (52) for communication with the switching unit.

8. Lift device with a cab and at least one lift door for opening and/or closing the cab and with a safety device for locking the lift door during operation, **characterised in that** the safety device is configured according to one of the preceding claims.

9. Lift device according to claim 8, **characterised in that** the contact link is attached to at least one of the lift doors and/or the contact receiver is attached to the cab.

10. Method for retrofitting a safety device according to one of claims 1 to 7 in a lift device.

11. Method according to claim 10, **characterised in that** the lift device comprises a safety circuit with at least one opening switch for achieving an opened or closed conduction state, **characterised in that** in a first method step the safety circuit is interrupted upstream and downstream of the opening switch (U).

12. Method according to claim 10 or 11, **characterised in that** in a second method step a safety device is introduced, **in that** the switching unit is inserted instead of the opening switch and the switching unit is connected to the safety device.

13. Retrofitting device for retrofitting safety devices of lift devices with safety circuits, which comprises a series circuit of openings switches, wherein the retrofitting device comprises a safety device (14, 20), that comprises at least two sensors, wherein the sensors can be switched between at least two switching states as a function of the closing state of the lift door, wherein the switching unit is configured as a second safety circuit and wherein furthermore the retrofitting device comprises a switching unit which can be switched by connection with the safety device between at least two switching states, wherein the switching unit can be inserted into the safety circuit instead of at least one of the opening circuits.

## Revendications

1. Dispositif de protection pour des dispositifs d'ascenseur pouvant déplacer une cabine par l'intermédiaire d'un entraînement (M), comportant :
- un premier circuit de sécurité (16, 26) qui comprend un état de conduction fermé et un état de conduction ouvert, comprenant un dispositif d'interruption (12, 15) destiné à interrompre l'entraînement en fonction de l'état de conduction du premier circuit de sécurité,
- un système de sécurité (14, 20) qui comporte au moins deux capteurs (1, 1', 10, 21, 41), lesquels peuvent être commutés entre au moins deux états de commutation en fonction de l'état de fermeture de la porte d'ascenseur, une unité de commutation (12, 12', 12", 25, 27) étant présente, laquelle peut être commutée entre au moins deux états de commutation par raccordement au système de sécurité (14, 20) et est configurée pour provoquer l'état de conduction fermé et/ou ouvert du premier circuit de sécurité, **caractérisé en ce que** le système de sécurité est conçu comme un second circuit de sécurité (14).

2. Dispositif de protection selon la revendication 1, **caractérisé en ce qu'**au moins un des capteurs (1, 10) comporte un pont de contact (3) et un récepteur de contact (2) destiné à recevoir le pont de contact, lesquels sont agencés de sorte que l'état de fermeture de la porte d'ascenseur peut être déterminé par la connexion entre le récepteur de contact et le pont de contact, le capteur étant conçu comme un capteur optique qui comporte un émetteur (4) destiné à émettre un signal optique et un récepteur (5) destiné à recevoir le signal optique, l'émetteur et le récepteur étant disposés sur le récepteur de contact et le pont de contact comportant au moins un élément de transmission (9 ; 9a, 9b, 9c) destiné à transmettre le signal optique.

3. Dispositif de protection selon l'une des revendications précédentes, **caractérisé en ce que** le premier circuit de sécurité comporte au moins un commutateur électromécanique (11).

4. Dispositif de protection selon l'une des revendications précédentes, **caractérisé en ce qu'**au moins deux des capteurs (10) sont montés en série.

5. Dispositif de protection selon l'une des revendications précédentes, **caractérisé en ce qu'**il est prévu un dispositif d'affichage destiné à afficher l'état de commutation des différents capteurs par association des différents états de commutation aux capteurs correspondants.

6. Dispositif de protection selon l'une des revendications précédentes, **caractérisé en ce que** l'unité de commutation est conçue pour mettre en oeuvre la communication avec les capteurs par modulation de l'intensité du courant et/ou de la tension.

7. Dispositif de protection selon l'une des revendications précédentes, **caractérisé en ce que** le capteur est conçu pour procéder à une modulation de sa résistance interne (52) afin d'établir une communication avec l'unité de commutation.

8. Dispositif d'ascenseur comprenant une cabine et au moins une porte d'ascenseur destinée à ouvrir et/ou à fermer la cabine, et comprenant un dispositif de protection destiné à verrouiller la porte d'ascenseur pendant le fonctionnement, **caractérisé en ce que** le dispositif de protection est conçu selon l'une des revendications précédentes.

9. Dispositif d'ascenseur selon la revendication 8, **caractérisé en ce que** le pont de contact est disposé sur au moins une des portes d'ascenseur et/ou le récepteur de contact est disposé sur la cabine.

10. Procédé pour équiper postérieurement un dispositif d'ascenseur d'un dispositif de protection selon l'une des revendications 1 à 7.

11. Procédé selon la revendication 10, **caractérisé en ce que** le dispositif d'ascenseur comporte un circuit de sécurité ayant au moins un commutateur d'ouverture destiné à provoquer un état de conduction ouvert ou fermé, **caractérisé en ce que** le circuit de sécurité est interrompu (U) en amont et en aval du commutateur d'ouverture au cours d'une première étape de procédé.

12. Procédé selon la revendication 10 ou 11, **caractérisé en ce qu'**un système de protection est inséré au cours d'une seconde étape de procédé en utilisant l'unité de commutation en lieu et place du ou des commutateurs d'ouverture et en connectant l'unité de commutation au système de protection.

13. Dispositif de mise à niveau pour équiper postérieurement des dispositifs de protection de dispositifs d'ascenseur avec des circuits de sécurité, lequel dispositif comporte un montage en série de commutateurs d'ouverture, le dispositif de mise à niveau comprenant un système de sécurité (14, 20) qui comporte au moins deux capteurs, les capteurs pouvant être commutés en fonction de l'état de fermeture de la porte d'ascenseur entre au moins deux états de commutation, le système de sécurité étant conçu comme un second circuit de sécurité et le dispositif de mise à niveau comprenant par ailleurs une unité de commutation qui peut être commutée entre au moins deux états de commutation par connexion avec le système de sécurité, l'unité de commutation pouvant être utilisée dans le circuit de sécurité en lieu et place d'au moins un des commutateurs d'ouverture.
